# EUROPEAN PATENT SPECIFICATION

(11) **EP 1 422 825 B1**
(45) Date of publication and mention of the grant of the patent: **01.02.2006**
(21) Application number: 02025986.7
(22) Date of filing: 21.11.2002
(51) Int. Cl.: H03L 7/14, H03J 7/02, H03L 1/00

(54) **Oscillator frequency control**
Oszillatorfrequenzsteuerung
Commande de fréquence d'un oscillateur

(43) Date of publication of application: 26.05.2004
(73) Proprietor: Sony Ericsson Mobile Communications AB, 221 88 Lund (SE)
(72) Inventor: Lindell, Bo, 181 46 Lidingo (SE); Kristiansson, Robert, 177 51 Järfälla (SE)
(74) Representative: Dahnér, Christer

(56) References cited:
- WO-A-94/21048
- US-A- 4 980 899
- US-A- 5 818 302

## Description

### TECHNICAL FIELD OF THE INVENTION

The present invention generally relates to the field of portable electronic devices and more particularly to a method and devices for the control of the frequency of a frequency source.

### DESCRIPTION OF RELATED ART

Cellular phones include local oscillators for generating frequencies. These frequencies are used for among other things clocking of circuits within the phone.

It is well known that these oscillators are not exact in operation, but there is often a drift of the frequency generated because of among other things temperature variations and ageing of the oscillator. Because the frequency is less exact, there is a need for adjusting or controlling the frequency so that it is stable. There exist control schemes for adjusting the frequency based on the temperature of the oscillator. The temperature compensation schemes based on temperature are normally based on static conditions. Different parts of a phone can however have different temperatures, which results in that the temperature compensation is less accurate than when used in the static condition.

It is furthermore known to use the carrier wave that a base station communicating with a phone is using for transmission of signals as a reference frequency for the oscillator. The frequency of the oscillator is then adjusted to the reference frequency by a simple control unit in the phone. However, there is one problem with this adjustment and that is that the phone can lose connection with the base station. Then there is no contact with the reference frequency, with a consequent possible drift of the oscillator frequency. In the GSM specification there are furthermore certain frequency and timing drift limits that are not allowed to be exceeded during temporary loss of connection with a base station. Such loss can under normal circumstances be in the order of 1 to 2 minutes. This requirement can be hard to live up to if the drift is not compensated for also during loss of connection.

US 5,113,416 describes a system for adjusting the frequency of transmission between a base station and a mobile station. The mobile station here detects the frequency of the signal received from the base station, determines whether the signal was received from the current base station and adjusts the output signal of a local crystal-controlled reference oscillator in accordance with the difference between the frequency of the output signal and the frequency of the received signal. This document therefore describes normal adjusting of frequency when contact is upheld with a base station. The document does not mention loss of connection with a base station

US 5,172,075 describes how a frequency source in a remote unit is controlled to maintain a stable frequency. In normal operation the frequency source is locked to an external reference frequency. In the absence of the reference frequency, the temperature of the frequency source is detected. Stored information relating to control signals is used to generate a control signal for controlling the output frequency of the frequency source. This document thus describes controlling of an oscillator in a portable electronic device, when there is no contact with a base station. The document also mentions that in one case the current temperature and the last control signal used for controlling the oscillator are used for calculating further control signals. The document is generally directed towards providing control of the oscillator frequency when there are long times of disconnection of the phone from the base station. An example given is in the order of several days. It furthermore uses the temperature of the oscillator to calculate control values and therefore needs to have a temperature sensor. Temperature sensors add to the costs of a device and also occupy more space, both of which are important to keep down in the field of cellular phones.

US5818302 discloses a control device for a frequency source using an external reference frequency generator arranged to: in case of contact with the reference frequency generator, supply a new control value to the frequency source (VCO), said value being determined by the frequency source frequency and the reference frequency and in case of no contact with the reference generator stores the last used control value and supply it to the frequency source (VCO) for controlling the latter. The control device is a part of a PLL using a DSP between the phase detector and the VCO for processing, storing and using the control value.

There is thus a need for a simpler way of controlling the frequency of an oscillator in a portable electronic device during temporary loss of connection with a base station.

### SUMMARY OF THE INVENTION

The present invention is therefore directed towards solving the problem of providing a simple and cost-efficent controlling of the frequency of a frequency source in a portable electronic device during temporary loss of communication with a reference frequency generator.

This problem is generally solved by calculating a rate of change value using the last used control value and at least the one control value immediately preceding the last control value used when contact was upheld with the reference source, and thereafter using this calculated rate of change value during temporary loss of communication.

One object of the present invention is thus to provide a portable electronic device having simple and cost-effective implementation for controlling the frequency of a frequency source included in the portable electronic device during temporary loss of communication with a reference frequency generator.

According to a first aspect of the present invention, this object is achieved by a portable electronic device arranged to be communicating with a reference frequency generator and comprising:
a receiving unit receiving a reference frequency,
a frequency source generating a frequency of the device, and
at least one control unit arranged to:
   in case of contact with the reference frequency generator:
      supply a new control value to the frequency source, said value being determined by the frequency source frequency and the reference frequency, and
      calculate a rate of change value at least based on the new and a previous control value,
   in case of no contact with the reference generator:
      calculate a new control value based on the rate of change value and the last used control value, and
      supply the new control value to the frequency source for controlling it.

A second aspect of the present invention includes the features of the first aspect, further comprising a detecting unit, detecting if the device is in contact with the reference frequency generator or if contact is lost.

A third aspect of the present invention includes the features of the first aspect, further comprising a control value store at least including the last used control value and a change of rate store at least including the rate of change associated with the last used control value.

A fourth aspect of the present invention includes the features of the first aspect, wherein there is a first control unit arranged to control the frequency source in case of contact with the reference frequency generator and a second control unit arranged to control the frequency source in case of no contact with the reference frequency generator.

A fifth aspect of the present invention includes the features of the fourth aspect, further comprising a switch arranged to connect the first control unit with the frequency source in case the detecting unit detects connection and to connect the second control unit with the frequency source in case it does not.

A sixth aspect of the present invention includes the features of the first aspect, further including a timer starting in case contact is lost with the reference frequency generator, wherein the control unit controlling the frequency source in case of no contact with the reference frequency generator is arranged to stop using the rate of change information if the counter reaches a predetermined value.

A seventh aspect of the present invention includes the features of the sixth aspect, wherein the timer is reset if contact with the reference frequency generator is established after being lost.

An eighth aspect of the present invention includes the features of the sixth aspect, wherein the predetermined value is dependent on the rate of change information. This has the advantage of stopping using rate of change values, when these are no longer reliable.

A ninth aspect of the present invention includes the features of the eighth aspect, wherein the predetermined value is high if the rate of change is low and is low if the rate of change is high.

A tenth aspect of the present invention includes the features of the first aspect, wherein it is a mobile phone and the reference frequency generator is a base station.

Another object of the present invention is directed towards providing a control device for a frequency source having simple and cost-effective implementation for controlling the frequency of the frequency source during temporary loss of communication with a reference frequency generator.

According to an eleventh aspect of the present invention, this object is achieved by a control device for a frequency source using an external reference frequency generator, arranged to:
in case of contact with the reference frequency generator:
   supply a new control value to the frequency source, said value being determined by the frequency source frequency and the reference frequency, and
   calculate a rate of change value at least based on the new and a previous control value,
in case of no contact with the reference generator:
   calculate a new control value based on the rate of change value and the last used control value, and
   supply the new control value to the frequency source for controlling it.

Another object of the present invention is to provide a method of controlling a frequency source that is simple and cost-effective to implement for controlling the frequency of the frequency source during temporary loss of communication with a reference frequency generator.

According to a twelfth aspect of the present invention, this object is achieved by a method of regulating a frequency source in a portable electronic device, comprising the steps of:
in case of reception of a reference frequency from an external reference frequency generator:
   supplying a new control value to the frequency source, said value being determined by the frequency source frequency and the reference frequency, and
   calculating a rate of change value at least based on the new and a previous control value,
in case of no reception of reference frequency signals from the external reference frequency generator,
   calculating a new control value based on the rate of changed value and the last used control value, and
   supplying the new control value to the frequency source for controlling it.

A thirteenth aspect of the present invention includes the features of the twelfth aspect, further comprising the step of detecting reception or no reception of reference frequency signals.

A fourteenth aspect of the present invention includes the features of the twelfth aspect, further comprising the step of storing the supplied control value and in case of reception of reference frequency signals from the external reference frequency generator also the rate of change value.

A fifteenth aspect of the present invention includes the features of the twelfth aspect, further including the steps of: in case of no reception of reference frequency signals from the external reference frequency generator: counting the time during which no reference frequency signals are received and stopping calculating new control values if the time reaches a preset time limit.

A sixteenth aspect of the present invention includes the features of the fifteenth aspect, further including the step of resetting the time if reference frequency signals are received again.

A seventeenth aspect of the present invention includes the features of the fifteenth aspect, wherein the predetermined value is dependent on the rate of change value.

An eighteenth aspect of the present invention includes the features of the seventeenth aspect, wherein the predetermined value is high if the rate of change value is low and is low if the rate of change value is high.

The present invention has many advantages. It is simple and easy to implement. It does not use any complicated or uncertain calculations of how the state of the device effects the frequency drift, like temperature, ageing and applied voltage. It fulfils the GSM requirements on limits of timing and frequency drift during a temporary loss of connection to a base station. It is cost-effective. Since it is based on controlling the frequency by the frequency from the reference frequency generator, which is already used in many portable electronic devices, it only requires small modifications of the device.

It should be emphasized that the term "comprises/comprising" when used in this specification is taken to specify the presence of stated features, integers, steps or components, but does not preclude the presence or addition of one or more other features, integers, steps, components or groups thereof.

### BRIEF DESCRIPTION OF THE DRAWINGS

The present invention will now be described in more detail in relation to the enclosed drawings, in which:
fig. 1 schematically shows a cellular phone communicating with a base station,
fig. 2 schematically shows a top view of the phone according to the invention,
fig. 3 shows a block schematic of the relevant parts of the phone according to a first embodiment of the invention,
fig. 4 shows a flow chart for performing the method according to the invention, and
fig. 5 shows a block schematic of the relevant parts of the phone according to a second embodiment of the invention.

### DETAILED DESCRIPTION OF EMBODIMENTS

The present invention relates to portable electronic device having a local frequency source. The portable electronic device according to the invention will in the following be described in relation to a cellular phone in a cellular network. This is just one example of a device according to the invention. It can also be a portable electronic device such as a lap top computer, a palm top computer, an electronic organizer, a smartphone or a communicator, as long as they can be connected to an external reference frequency generator. This can in the case of a lap top computer take place by using a PC-card or a similar device connected to the computer for communication with a cellular network.

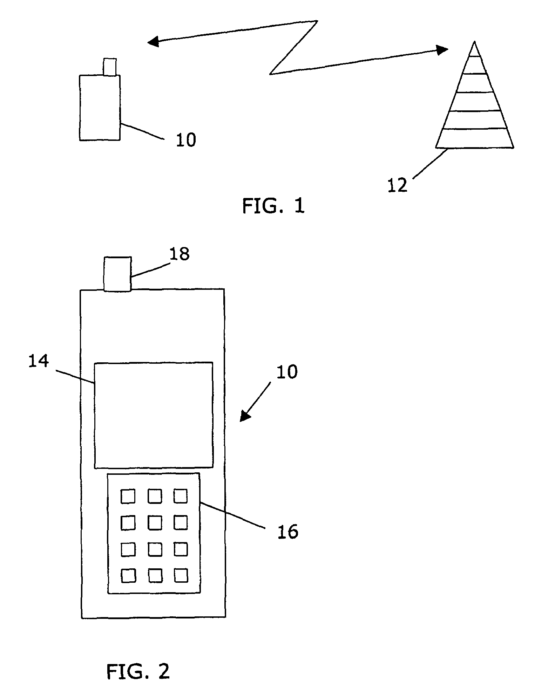

Fig. 1 schematically shows a phone 10 according to the invention. The phone communicates with a base station 12 of a cellular network. During this communication both the phone and the base station modulate transmitted signals on a carrier wave. The base station 12 is thus equipped with a frequency generator, generating the frequency of the carrier wave. The phone 10 uses this carrier wave as a reference frequency for it's internal local frequency source, the details of which, will be described in more detail later on. The base station 12 thus includes a reference frequency generator for the phone 10.

Fig. 2 shows a phone according to the invention. The phone 10 includes a display 14, a keypad 16 and an antenna 18 protruding from the body of the phone, which is used for communication with the base station. It should be realised that the antenna can, as an alternative, be in-built.

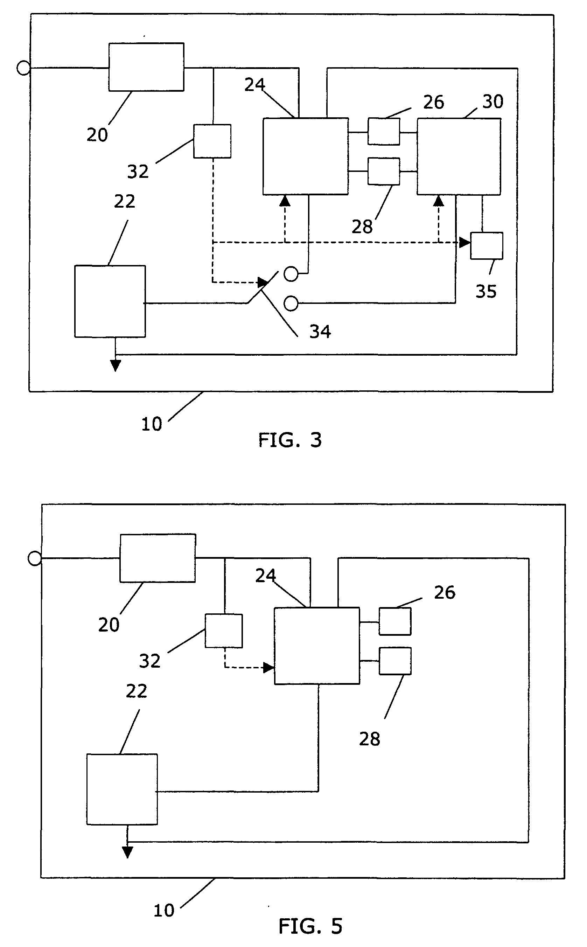

Fig. 3 shows a block schematic of the relevant parts of the phone 10 according to a first embodiment of the present invention. The device includes a receiver 20 connected to the antenna (not shown). The receiver 20 is connected to a first control unit 24 as well as to a detecting unit 32. The first control unit 24 is connected to a control value store 26 and to a change of rate store 28. A second control unit 30 is also connected to the control value store 26 and to the change of rate store 28. The second control unit 30 is also connected to a timer 35. The detecting unit 32 controls a switch 34 via a control signal. The detection unit 32 also supplies the control signal to the first and the second control units 24 and 30 as well as to the timer 35. The supply of this control signal is indicated with dashed lines in the figure. The switch 34 is connected to a control input of the local frequency source 22, which in the preferred embodiment is a local frequency oscillator. The switch 34 is switchable between two positions, a first connecting the control input of the oscillator 22 with the first control unit 24 and a second connecting the control input of the oscillator 22 with the second control unit 30. The oscillator 22 also has an output providing an output frequency, to which output the first control unit 24 is also connected. The frequency of the local oscillator 22 is used in the phone for a number of things, where perhaps the most important one is as a base for providing clocking signals used for the different parts of the phone.

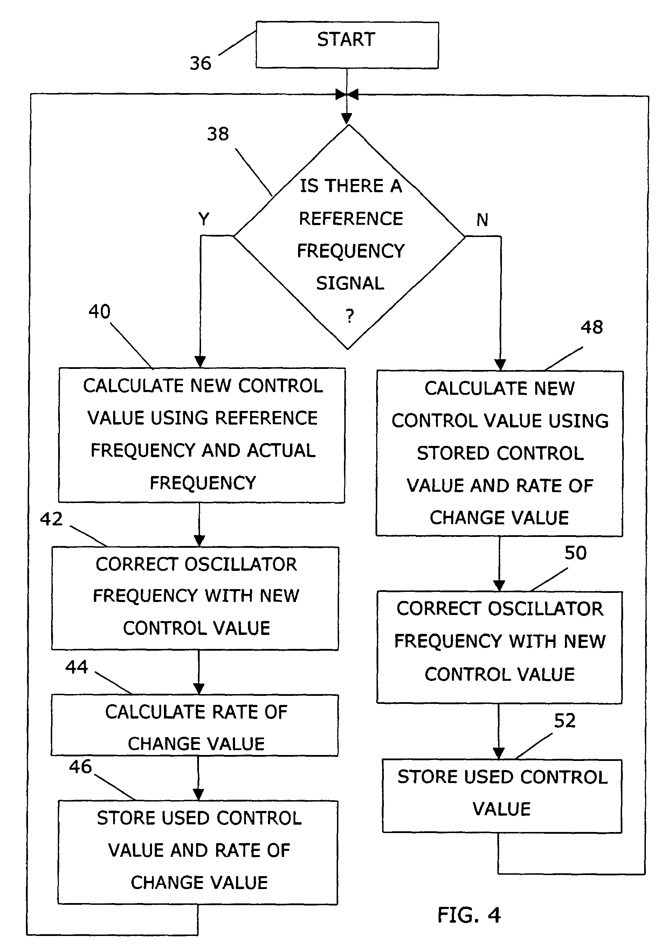

The way the present invention operates will now be described with further reference to fig. 4, which shows a flow chart of the method according to the invention. The receiver 20 receives information modulated onto a carrier wave. The information is demodulated in the receiver 20 according to known principles and used in normal fashion in the phone. This is not a real part of the invention and is therefore not shown in the drawings and described further. The receiver 20 does however extract the frequency of the carrier wave for use as a reference frequency signal in order to control the local oscillator 22. This frequency is supplied to the first control unit 24. The presence of this frequency is also detected by the detecting unit 32 and used for providing the control signal switching the switch 34 to connect the control input of the oscillator 22 to the first control unit 24. The control signal of the detection unit 32 is also used for enabling the first control unit 24 and disabling the second control unit 30. The method is therefore started by the reception of the carrier wave in the first control unit 24, step 36. Thus, if there is a reference frequency signal present, step 38, the first control unit 24 is activated for control of the oscillator 22. In order to perform this controlling, the first control unit 24 receives the output signal of the local oscillator 22, i.e. the frequency to be controlled or actual frequency, and the received reference frequency and calculates a new control value based on these, step 40. The new control value is in its simplest form calculated by inputting the difference between the local oscillator frequency and the reference frequency. As an alternative this control can include an amplification of the difference. More complex ways of controlling the oscillator might be used, although it is preferred to keep it as simple as possible. Because of this control value, the oscillator 22 adjusts its frequency so that it is set equal to the reference frequency. The reason for the need to adjust the oscillator frequency is that it experiences drift, which can be because of varying temperature or because of ageing of the oscillator. The temperature can be varying because of changes in the environmental temperature of the phone and as a result of internal power dissipation. The first control unit 24 then calculates a rate of change value associated with the new control value, step 44. This is in it's simplest version done by dividing the difference between the just used control value and a just previously used control value with the time interval between the values, i.e. calculating a derivative. More complex ways of calculating rate of change are also possible, like taking into account more previous control values. The most recently used control value is then stored in the control value store 26 and the rate of change value is stored in the rate of change store 28, step 46. These steps are then repeated for as long as there is a connection between the phone and the base station. In the preferred embodiment, the stores 26 and 28 only store one control value and one rate of change value at a time, where a new value replaces an earlier value. It is however possible to have more values stored such that the stores will include several earlier control values and several earlier rate of change values. These could then be used for more complex calculations of rate of change.

If contact is then temporarily lost with the base station the receiver 20 will not receive a reference frequency, step 38. No reference frequency is then output to the first control unit 24. The detecting unit 32 detects the absence of reference frequency and will then provide a control signal disabling the first control unit 24, enabling the second control unit 30 as well as switching the switch 34 to connect the second control unit 30 with the control input of the oscillator 22. Therefore the second control unit 30 will now start operating instead of the first control unit 24. The second control unit 30 then takes the last used control value stored in control value store 26 and the last calculated rate of change value stored in rate of change store 28 and calculates a new control value, step 48. The new control value is then supplied to the oscillator 22 for correction of its frequency, step 50. Thereafter the used control value is stored in the control value store 26, step 52. Note that no more rate of change values are calculated in this embodiment, but the same rate of change value is used for all new control values calculated during the time when no reference frequency signal is received. This is done under the assumption that the drift is linear, which assumption greatly simplifies the device. The above-mentioned calculations then continue to be made as long as there is no reference frequency available. It is possible that a more complex way of calculating rate of change is used, which uses several previous control values and interpolation for providing future rate of change values.

The thus described scheme provides a cost-effective and simple control of the local oscillator. This is especially the case since the controlling of the oscillator using the base station frequency is already used in known phones. With these schemes no real account is taken for the reason of the drift of the oscillator. The system just notes that there is a drift, how big it is and how it is changing by calculating rate of change and then applying this knowledge when no reference signal exists. There is no need for expensive or complicated temperature measurements or complicated models of how oscillators age or how frequencies change with temperature. This solution therefore works well when contact is temporarily lost with a base station, where the time of lost contact for example is in the region of a half to one minute.

The described method can be modified. The time the second control unit 30 can use the same rate of change value for calculating new control values is limited. If the rate of change is high, this time is short, but if it is low, it can be used for a longer time. The timer 35 therefore receives the control signal from the detecting unit 32. This timer 35 starts counting when no reference frequency is available and continues counting until one of two things happens. Either a reference frequency signal is received, which resets the timer 35 or the timer 35 reaches a predetermined value. The second control unit 30 continuously checks the status of the timer and when it reaches the predetermined value, the second control unit 30 stops calculating new control values and uses the same one all the time. The predetermined value can be set to different levels depending on how high the rate of change value is. If it is a high value, the predetermined value is low and if it is a low value the predetermined value is high.

The detecting unit, the two control units the switch, the timer and the two stores make up a control device for the oscillator.

There are many variations that can be made to the invention. The frequency of the carrier way does not have to exactly correspond to the desired frequency of the oscillator. It can be different, but then the correct reference frequency is obtained by dividing or multiplying the frequency of the carrier wave. It is furthermore not necessary to have two control units. It is equally as well possible to have just one, which is shown in fig. 5 showing a block schematic of the relevant parts of the phone according to a second embodiment of the invention. Here the one control unit takes care of both phases of controlling, i.e. in case there is a reference frequency present and in case there is no such frequency present and changes mode of operation in dependence of control signal received from the detection unit 22. Therefore there is no switch. In the figure also the timer has been omitted. It should however be realised that it is fully possible to include such a timer though. In all other respects the second embodiment is identical to the first and therefore the same reference numerals are used as in fig. 3.

The receiving unit is in the case of a cellular phone provided in the form of the actual radio receiver. In case the device is a laptop or other similar device communicating with a radio network via a PC card or similar device, the receiving unit is just an interface towards the PC card, where the carrier wave is received.

It is furthermore possible to vary the second embodiment even more. It is possible to include the detecting unit and the two stores in the sole control unit as well.

The control units are preferably provided in the form of a processor cooperating with program code stored in a program memory. The invention is therefore easy to implement in a phone by just adding some extra software, since some of it is already there. It also fulfils the requirements for limits on timing and frequency drift during loss of connection with a base station according to the GSM requirements. For these and other reasons the present invention is only to be limited by the following claims.

## Claims

1. Control device (24, 26, 28, 30, 32, 34, 35; 24, 26, 28, 32) for a frequency source (22) using an external reference frequency generator (12), arranged to:
in case of contact with the reference frequency generator (22):
supply a new control value to the frequency source, said value being determined by the frequency source frequency and the reference frequency, and
calculate a rate of change value at least based on the new and a previous control value,
in case of no contact with the reference generator:
calculate a new control value based on the rate of change value and the last used control value, and
supply the new control value to the frequency source for controlling it.

2. Portable electronic device (10) arranged to be communicating with a reference frequency generator (12) and comprising:
a receiving unit (20) receiving a reference frequency,
a frequency source (22) generating a frequency of the device, and
at least one control device (24, 30; 24) according to claim 1.

3. Portable electronic device according to claim 2, further comprising a detecting unit (32) detecting if the device is in contact with the reference frequency generator or if contact is lost.

4. Portable electronic device according to claim 2 or 3, further comprising a control value store (26) at least including the last used control value and a change of rate store (28) at least including the rate of change associated with the last used control value.

5. Portable electronic device according to any of claims 2-4, wherein there is a first control unit (24) arranged to control the frequency source in case of contact with the reference frequency generator and a second control unit (30) arranged to control the frequency source in case of no contact with the reference frequency generator.

6. Portable electronic device according to claim 5, further comprising a switch (34) arranged to connect the first control unit (24) with the frequency source in case the detecting unit detects connection and to connect the second control unit (30) with the frequency source in case it does not.

7. Portable electronic device according to any of claims 2 - 6, further including a timer (35) starting in case contact is lost with the reference frequency generator, wherein the control unit (30) controlling the frequency source in case of no contact with the reference frequency generator (22) is arranged to stop using the rate of change information if the counter reaches a predetermined value.

8. Portable electronic device according to claim 7, wherein the timer (35) is reset if contact with the reference frequency generator is established after being lost.

9. Portable electronic device according to claim 7 or 8, wherein the predetermined value is dependent on the rate of change information.

10. Portable electronic device according to claim 9, wherein the predetermined value is high if the rate of change is low and is low if the rate of change is high.

11. Portable electronic device according to any of claims 2 - 10, wherein it is a mobile phone and the reference frequency generator is a base station.

12. Method of regulating an frequency source in a portable electronic device, comprising the steps of:
in case of reception of a reference frequency from an external reference frequency generator, (step 38):
supplying a new control value to the frequency source, (step 42) said value being determined by the frequency source frequency and the reference frequency, (step 40), and
calculating a rate of change value at least based on the new and a previous control value, (step 44),
in case of no reception of reference frequency signals from the external reference frequency generator, (step 38):
calculating a new control value based on the rate of changed value and the last used control value, (step 48), and
supplying the new control value to the frequency source for controlling it, (step 52).

13. Method according to claim 12, further comprising the step of detecting reception or no reception of reference frequency signals.

14. Method according to claim 12 or 13, further comprising the step of storing the supplied control value, (steps 46, 52) and in case of reception of reference frequency signals from the external reference frequency generator also the rate of change value (step 46).

15. Method according to any of claims 12 - 14, further including the steps of: in case of no reception of reference frequency signals from the external reference frequency generator: counting the time during which no reference frequency signals are received, and stopping calculating new control values if the time reaches a preset time limit.

16. Method according to claim 15, further including the step of resetting the time if reference frequency signals are received again.

17. Method according to claim 15 or 16, wherein the predetermined value is dependent on the rate of change value.

18. Method according to claim 17, wherein the predetermined value is high if the rate of change value is low and is low if the rate of change value is high.

## Patentansprüche

1. Steuereinrichtung (24, 26, 28, 30, 32, 34, 35; 24, 26, 28, 32) für eine Frequenzquelle (22), wobei ein externer Referenzsequenzgenerator (12) verwendet wird, die eingerichtet ist, um:
im Fall eines Kontakts mit dem Referenzfrequenzgenerator (22):
einen neuen Steuerungswert zur Frequenzquelle zu liefern, wobei der Wert durch die Frequenzquellenfrequenz und die Referenzfrequenz bestimmt wird, und
eine Änderungswertrate zumindest auf der Basis des neuen und eines vorherigen Steuerungswerts zu berechnen,
im Falle keines Kontakts mit dem Referenzgenerator:
einen neuen Steuerungswert auf der Basis der Änderungswertrate und des letzten verwendeten Steuerungswerts zu berechnen, und
den neuen Steuerungswert zur Frequenzquelle, um diese zu steuern, zu liefern.

2. Tragbare elektronische Einrichtung (10), die eingerichtet ist, in Kommunikation mit einem Referenzfrequenzgenerator (12) zu sein, und aufweist:
eine Empfangseinheit (20), die eine Referenzfrequenz empfängt;
eine Frequenzquelle (22), die eine Frequenz der Einrichtung erzeugt, und zumindest eine Steuerungseinrichtung (24, 30; 24) nach Anspruch 1.

3. Tragbare elektronische Einrichtung nach Anspruch 2, die weiter eine Ermittlungseinheit (32) aufweist, die ermittelt, wenn die Einrichtung in Kontakt mit dem Referenzfrequenzgenerator ist oder wenn Kontakt verloren ist.

4. Tragbare elektronische Einrichtung nach Anspruch 2 oder 3, die einen Steuerungswertspeicher (26), der zumindest den letzten verwendeten Steuerungswert aufweist, und einen Änderungsratenspeicher (28) umfasst, der zumindest die Änderungsrate in Verbindung mit dem letzten verwendeten Steuerungswert aufweist.

5. Tragbare elektronische Einrichtung nach einem der Ansprüche 2 bis 4, wobei es eine erste Steuerungseinrichtung (24) gibt, die eingerichtet ist, die Frequenzquelle im Fall von Kontakt mit dem Referenzfrequenzgenerator zu steuern, und eine zweite Steuerungseinrichtung (30), die eingerichtet ist, die Frequenzquelle im Fall keines Kontakts mit dem Referenzfrequenzgenerator zu steuern.

6. Tragbare elektronische Einrichtung nach Anspruch 5, die außerdem einen Schalter (34) aufweist, der eingerichtet ist, die erste Steuerungseinrichtung (24) mit der Frequenzquelle in dem Fall zu verbinden, dass die Ermittlungseinheit die Verbindung ermittelt, und die zweite Steuerungseinrichtung (30) mit der Frequenzquelle zu verbinden, im Fall, dass sie dies nicht tut.

7. Tragbare elektronische Einrichtung nach einem der Ansprüche 2 bis 6, die außerdem einen Timer (35) aufweist, der startet, wenn Kontakt mit dem Referenzfrequenzgenerator verloren ist, wobei die Steuerungseinrichtung (30), die die Frequenzquelle steuert, wenn kein Kontakt mit dem Referenzfrequenzgenerator (22) vorher eingerichtet ist, um die Verwendung der Änderungsinformationsrate zu stoppen, wenn der Zähler einen vorher festgelegten Wert erreicht.

8. Tragbare elektronische Einrichtung nach Anspruch 7, wobei der Timer (35) zurückgesetzt wird, wenn Kontakt mit dem Referenzfrequenzgenerator, nachdem dieser verloren ist, eingerichtet ist.

9. Tragbare elektronische Einrichtung nach Anspruch 7 oder 8, wobei der vorher festgelegte Wert von der Änderungsinformationsrate abhängig ist.

10. Tragbare elektronische Einrichtung nach Anspruch 9, wobei der vorher festgelegte Wert hoch ist, wenn die Änderungsrate niedrig ist, und niedrig ist, wenn die Änderungsrate hoch ist.

11. Tragbare elektronische Einrichtung nach einem der Ansprüche 2-10, wobei diese ein Mobiltelefon ist und der Referenzfrequenzgenerator eine Basisstation ist.

12. Verfahren zum Regeln einer Frequenzquelle in einer tragbaren elektronischen Einrichtung, welches folgende Schritte aufweist:
im Fall eines Empfangs einer Referenzfrequenz von einem externen Referenzfrequenzgenerator (Schritt 38):
Liefern eines neuen Steuerungswerts zur Frequenzquelle (Schritt S42);
wobei der Wert durch die Frequenzquellenfrequenz und die Referenzfrequenz bestimmt wird (Schritt 40), und
Berechnen einer Änderungswertrate zumindest auf der Basis des neuen und eines vorherigen Steuerungswerts (Schritt S44),
im Fall keines Empfangs von Referenzfrequenzsignalen vom externen Referenzfrequenzgenerator (Schritt 38):
Berechnen eines neuen Steuerungswerts auf der Basis der Änderungswertrate und des letzten verwendeten Steuerungswerts (Schritt 48), und
Liefern des neuen Steuerungswerts zur Frequenzquelle, um diese zu steuern (Schritt 52).

13. Verfahren nach Anspruch 12, welches außerdem den Schritt zum Ermitteln von Empfang oder Nicht-Empfang von Referenzfrequenzsignalen aufweist.

14. Verfahren nach Anspruch 12 oder 13, welches außerdem den Schritt zum Speichern des gelieferten Steuerungswerts (Schritt 46, 52) und im Fall von Empfang von Referenzfrequenzsignalen vom externen Referenzfrequenzgenerator auch der Änderungswertrate (Schritt 46) aufweist.

15. Verfahren nach einem der Ansprüche 12-14, welches außerdem folgende Schritte aufweist:
im Fall von Nicht-Empfang von Referenzfrequenzsignalen vom externen Referenzfrequenzgenerator: Zählen der Zeit, während der keine Referenzfrequenzsignale empfangen werden und Stoppen von Berechnung neuer Steuerungswerte, wenn die Zeit eine vorher festgelegte Zeitgrenze erreicht.

16. Verfahren nach Anspruch 15, welches außerdem dem Schritt zum Zurücksetzen der Zeit aufweist, wenn die Referenzfrequenzsignale wieder empfangen werden.

17. Verfahren nach Anspruch 15 oder 16, wobei der vorher festgelegte Wert von der Änderungswertrate abhängig ist.

18. Verfahren nach Anspruch 17, wobei der vorher festgelegte Wert hoch ist, wenn die Änderungswertrate niedrig ist, und niedrig ist, wenn die Änderungswertrate hoch ist.

## Revendications

1. Dispositif de commande (24, 26, 28, 30, 32, 34, 35 ; 24, 26, 28, 32) pour une source de fréquences (22) utilisant un générateur de fréquences de référence extérieur (12), conçu pour :
en cas de contact avec le générateur de fréquences de référence (12) :
fournir une nouvelle valeur de commande à la source de fréquences, ladite valeur étant déterminée par la fréquence de la source de fréquences et la fréquence de référence, et
calculer une valeur de vitesse de variation au moins basée sur la nouvelle valeur de commande et une valeur antérieure,
en cas d'absence de contact avec le générateur de référence :
calculer une nouvelle valeur de commande fondée sur la valeur de la vitesse de variation et la dernière valeur de commande utilisée, et
fournir la nouvelle valeur de commande à la source de fréquences, afin de la commander.

2. Dispositif électronique portatif (10) conçu pour communiquer avec un générateur de fréquences de référence (12) et comprenant :
une unité de réception (20) recevant une fréquence de référence,
une source de fréquences (22) produisant une fréquence du dispositif, et
au moins un dispositif de commande (24, 30 ; 24) selon la revendication 1.

3. Dispositif électronique portatif selon la revendication 2, comprenant en outre une unité de détection (32) qui détecte si le dispositif est en contact avec le générateur de fréquences de référence ou si le contact est rompu.

4. Dispositif électronique portatif selon la revendication 2 ou 3, comprenant en outre une mémoire de valeurs de commande (26) contenant au moins la dernière valeur de commande utilisée et une mémoire de vitesses de variation (28) contenant au moins la vitesse de variation associée à la dernière valeur de commande utilisée.

5. Dispositif électronique portatif selon l'une quelconque des revendications 2 à 4, dans lequel il existe une première unité de commande (24) conçue pour commander la source de fréquences en cas de contact avec le générateur de fréquences de référence et une seconde unité de commande (30) conçue pour commander la source de fréquences en cas d'absence de contact avec le générateur de fréquences de référence.

6. Dispositif électronique portatif selon la revendication 5, comprenant en outre un commutateur (34) conçu pour connecter la première unité de commande (24) à la source de fréquences dans le cas où l'unité de détection détecte la connexion et pour connecter la seconde unité de commande (30) à la source de fréquences dans le cas contraire.

7. Dispositif électronique portatif selon l'une quelconque des revendications 2 à 6, comprenant en outre un compteur de temps (35) qui démarre lorsque le contact est rompu avec le générateur de fréquences de référence, dans lequel l'unité de commande (30) commandant la source de fréquences en l'absence de contact avec le générateur de fréquences de référence (12) est conçue pour cesser d'utiliser les informations de vitesse de variation lorsque le compteur atteint une valeur prédéterminée.

8. Dispositif électronique portatif selon la revendication 7, dans lequel le compteur de temps (35) est réinitialisé lorsque le contact avec le générateur de fréquences de référence est établi après avoir été rompu.

9. Dispositif électronique portatif selon la revendication 7 ou 8, dans lequel la valeur prédéterminée dépend des informations de vitesse de variation.

10. Dispositif électronique portatif selon la revendication 9, dans lequel la valeur prédéterminée est élevée lorsque la vitesse de variation est faible et basse lorsque la vitesse de variation est forte.

11. Dispositif électronique portatif selon l'une quelconque des revendications 2 à 10, dans lequel celui-ci est un téléphone mobile et le générateur de fréquences de référence est une station de base.

12. Procédé de régulation d'une source de fréquences dans un dispositif électronique portatif, comprenant les étapes consistant à :
en cas de réception d'une fréquence de référence depuis un générateur de fréquences de référence extérieur (étape 38) :
fournir une nouvelle valeur de commande à la source de fréquences (étape 42), ladite valeur étant déterminée par la fréquence de la source de fréquences et la fréquence de référence (étape 40), et
calculer une valeur de vitesse de variation au moins basée sur la nouvelle valeur de commande et une valeur antérieure (étape 44),
en cas de non-réception de signaux de fréquence de référence depuis le générateur de fréquences de référence extérieur (étape 38) :
calculer une nouvelle valeur de commande fondée sur la valeur de la vitesse de variation et la dernière valeur de commande utilisée (étape 48), et
fournir la nouvelle valeur de commande à la source de fréquences, afin de la commander (étape 52).

13. Procédé selon la revendication 12, comprenant en outre l'étape consistant à détecter la réception ou la non-réception de signaux de fréquence de référence.

14. Procédé selon la revendication 12 ou 13, comprenant en outre l'étape consistant à mémoriser la valeur de commande fournie (étapes 46, 52) et, en cas de réception des signaux de fréquence de référence depuis le générateur de fréquences de référence extérieur, également la valeur de la vitesse de variation (étape 46).

15. Procédé selon l'une quelconque des revendications 12 à 14, incluant en outre les étapes consistant à : en cas de non-réception des signaux de fréquence de référence du générateur de fréquences de référence extérieur : compter le temps pendant lequel aucun signal de fréquence de référence n'est reçu et arrêter le calcul de nouvelles valeurs de commande lorsque le temps atteint une limite de temps prédéterminée.

16. Procédé selon la revendication 15, comprenant en outre l'étape consistant à réinitialiser le temps si des signaux de fréquence de référence sont à nouveau reçus.

17. Procédé selon la revendication 15 ou 16, dans lequel la valeur prédéterminée dépend de la valeur de la vitesse de variation.

18. Procédé selon la revendication 17, dans lequel la valeur prédéterminée est élevée lorsque la vitesse de variation est faible et basse lorsque la vitesse de variation est forte.
